# EUROPEAN PATENT APPLICATION

(11) **EP 4 692 735 A1**
(43) Date of publication of application: **11.02.2026**
(21) Application number: 24193863.8
(22) Date of filing: 09.08.2024
(51) Int. Cl.: G01D 21/02, G01D 11/24, G01D 11/30

(54) **SENSOR MODULE AND MEASURING DEVICE**

(71) Applicant: ABB SCHWEIZ AG, 5400 Baden (CH)
(72) Inventor: Boron, Artur, 32-070 Czernichow (PL); Pypec, Stefan, 31-215 Krakow (PL)
(74) Representative: AOMB Polska Sp. z.o.o.

(57) **Abstract**

The present invention relates to wireless energy harvesting sensors, and more precisely to a measuring device with a sensor module with sensor electronics and a transducer module. The invention discloses sensor module comprising: a housing part (1), and a carrier part (2). The carrier part (2) comprising a front panel (3) and a holding part (4) attached to the front panel (3), wherein the front panel (3) comprises connecting means (5) suitable for transmitting electrical signals through the front panel (3). The holding part (4) comprising an interior side (6) configured to hold at least one printed circuit board (7), PCB. The housing part (1) is configured to receive the carrier part (2) such that the holding part (4) is enclosed within the housing part (1), preferably the housing part (1) comprising at least one interior wall (9)with at least one guide (8) which is suitable and configured to have the carrier part (2) inserted. The invention discloses a measuring device comprising: a sensor module, an energy harvesting transducer (13), preferably configured to convert an energy from a measured physical quantity, at least one printed circuit board (7), PCB, configured to obtain the energy from the energy harvesting transducer (13), store the energy, indicate a level of the energy being stored, measure the measured physical quantity, and transmit a measured data wirelessly. The printed circuit board (7), PCB, is mounted on a carrier part (2) of the sensor module and the PCB (7) is electrically coupled, through connecting means (5) in a front panel (3) of the carrier part (2) of the sensor module, with the energy harvesting transducer (13).

## Description

### Technicalfield

The present invention relates to wireless energy harvesting sensors, and more precisely to a measuring device with a sensor module with sensor electronics and a transducer module.

### Background of the disclosure

Document US20180351404A1 discloses a self-powered wireless sensor and sensor module. The wireless sensor and sensor module includes a harvesting circuit configured to collect power from an external environment, a sensor unit configured to comprise one or more sensors, a controller configured to store data collected by the sensor unit, and a wireless communication unit configured to transmit the sensor data stored in the controller to a destination. The harvesting circuit may include a voltage doubler. Accordingly, output voltage efficiency of the wireless sensor and sensor module can be improved.

Document US20140021936A1 discloses current transducer. The current transducer includes a magnetic core configured to at least partially encircle a magnetic flux generated by a conductor. At least one coil is coupled to the magnetic core and the magnetic core comprises a superm-alloy material.

Document US20110248846A1 discloses a wireless sensing module with extended service life containing at least one sensor of a physical parameter, a data acquisition hardware acquiring output electrical signals from at least one sensor and converting it into digital measurement data, a microcontroller, a non-volatile memory, at least one transceiver for wireless communication with external wireless devices, at least one battery, including at least one re-chargeable battery, at least one energy harvesting device, a power management circuit, and at least one antenna. All components of the wireless sensing module are mounted on a printed circuit board and placed into an enclosure providing mechanical, chemical, electrical and environmental protection. The wireless sensing modules can be used in different applications, including long-term condition monitoring of structures.

Document US7081693B2 discloses a device for powering a load from an ambient source of energy. The device includes an energy harvesting device for harvesting energy from the ambient source of energy wherein the rate energy is harvested from the ambient source of energy is below that required for directly powering the load. A storage device is connected to the energy harvesting device. The storage device receives electrical energy from the energy harvesting device and is for storing the electrical energy. A controller is connected to the storage device is for monitoring the amount of electrical energy stored in the storage device and for switchable connecting the storage device to the load when the stored energy exceeds a first threshold. The system can be used for powering a sensor and for transmitting sensor data, such as tire pressure.

Document EP4009056A1 discloses a sensing device for monitoring an electrical component or apparatus. The sensing device is attachable to an electrical conductor and includes a sensor for measuring at least one physical property, a wireless communication unit for transmitting measurement data to a receiver, an energy harvesting unit configured to harvest energy from a current flowing through the electrical conductor and comprising an electromagnetic coil wound around a core, and a connection mechanism to make the core connectable to a strap comprising a material having a high magnetic permeability. The sensing device is configured to be operable when no strap is connected to the core and energy is harvested via an open magnetic circuit as well as when a strap is connected to the core and energy is harvested via a closed magnetic circuit.

Document EP3830804B1 discloses a radio sensor node. The radio sensor node comprises a sensor unit for detecting a measured variable and outputting an analogue electric sensor signal, an energy harvesting unit for harvesting energy from the sensor signal (S), a signal processing unit for generating a transmission signal from the sensor signal and a radio unit for transmitting the transmission signal as a radio signal. The sensor signal can be supplied alternately to the energy harvesting unit and to the signal processing unit.

Document CN202793627U discloses a bus joint measuring WSN node, relating to the field of power monitoring and wireless sensing field. The wireless temperature measuring system, direct-contact temperature measuring combined wireless data collecting technology and effectively solves the problem that high pressure environment accurate data acquisition and collection apparatus with the insulation problem of the high voltage device. capable of accurately and stably measuring bus joint temperature, detecting bus bar temperature in real time. and the unique structure design, convenient mounting, use is not limited by installation position, the use environment is limited. energy supply of the wireless node is self-powered power supply, collecting energy and converts the stable power supply can be used as wireless node of the energy processing circuit from the bus peripheral magnetic field, so that the device can work without permanent battery state.

Every wired sensor needs at least 2 wires to get power supply from the system control node and to transmit data. 1-wire type of protocols also need 2 conductors. Usually, additionally at least one wire (typically two or more) is required for communication. Each wire drives the size of the sensor and control node because it needs to be connected. Star architecture is the most convenient from routing, sealing and robustness perspective but creates the biggest number of wired connections to system control node. Bus topology mitigates these problems but drives the size of the sensor as they need to have more connectors for passing through the signals which also are more difficult to seal. In case of failure, a larger number of sensors may not be accessible.

Sensors become more and more popular and used in an industry what created a problem of huge number of wires routed to system control nodes. Sensors are used to provide better diagnostic systems and allow preventive maintenance instead of failure. Wires take up a lot of space, generate costs of installation, reduce cooling efficiency of electrical equipment by blocking the airflow and may cause problems with electrical isolation. Known solution from the state of the art connect sensors to local power or use a battery what causes that sensors are not independent from wires and batteries. There are known solutions which use wireless power transfer like RFID technology, but it has limited operating range and limitations in applications.

### Summary of the disclosure

It is a goal of this invention to provide sufficiently independent construction of wireless energy harvesting sensors.

According to an aspect of the present invention there is provided a sensor module comprising: a housing part, and a carrier part. The carrier part comprising a front panel and a holding part attached to the front panel, wherein the front panel comprises connecting means suitable for transmitting electrical signals through the front panel. The holding part comprising an interior side configured to hold at least one printed circuit board, PCB. The housing part is configured to receive the carrier part such that the holding part is enclosed within the housing part, preferably the housing part comprising at least one interior wall with at least one guide which is suitable and configured to have the carrier part inserted.

Preferably the connecting means is a wire interface, a connector or at least one through hole.

In one embodiment at least two walls of the housing part are configured to receive the carrier part in a manner of sliding movement of the carrier part.

The housing part comprises a mechanical fixture configured to assembly the sensor module to a final location or to attach the sensor module for an integration with another module, wherein the mechanical fixture is preferably a CT holder or strap holder.

In one of the preferred embodiments the carrier part is kept inside the housing part by a sticker, latches, snaps or a plate with screws.

According to second aspect of the present invention there is provided a measuring device comprising:
a sensor module,
an energy harvesting transducer, preferably configured to convert an energy from a measured physical quantity,
at least one printed circuit board, PCB, configured to obtain the energy from the energy harvesting transducer, store the energy, indicate a level of the energy being stored, measure the measured physical quantity, and transmit a measured data wirelessly,
where the printed circuit board, PCB, is mounted on a carrier part of the sensor module and the PCB is electrically coupled, through connecting means in a front panel of the carrier part of the sensor module, with the energy harvesting transducer.

The printed circuit board, PCB, comprises an energy harvester or an energy storage or a load switch or a voltage supervisor or at least one sensor or a BLE SoC.

Preferably the sensor is a temperature sensor or a RH sensor or a light sensor or a magnetic sensor or an accelerometer sensor or a pressure sensor.

In one embodiment the connection means is a wire interface or a connector and the connection of the sensor module and the energy harvesting transducer is provided by a wire connection between them.

In one of the preferred embodiments the sensor module and the energy harvesting transducer are attached one to another in a separable manner by a mechanical fixture.

### Advantages of the disclosure

According to the disclosure, the effect of the invention is to provide higher flexibility of the installation of the module, simpler logistics and lower production cost. The control system, being the matter of this invention, allows to keep single electronics assembly used with multiple mechanical packages allowing multiple integration options in different possible customer electronic arrangements and at the same keeping simplicity of the installation of the control system.

The inventions exclude a need of power supply and communication wires. Therefore, the sensor does not require battery replacement or charging. The same PCBs and mechanical parts can be integrated with different transducer during customer installation what created this invention universal and allows to reduce the number of elements for production.

### Brief description of the drawings

The present disclosure will be discussed with reference to drawings, where:
Fig. 1 - depicts a housing part and a carrier part,
Fig. 2 - depicts the carrier part with plugged wires,
Fig. 3 - depicts the housing part and view on its interior,
Fig. 4-depicts the housing part with a mechanical fixture being a CT holder type,
Fig. 5- depicts the housing part with a mechanical fixture being a strap holder,
Fig. 6 - depicts the sensor module with attached an energy harvesting transducer, a measuring device,
Fig. 7 - depicts the sensor module with an attached sticker,
Fig. 8 - depicts a block diagram with the sensor module with possible sensors.

### Detailed description of the disclosure

For a proper understanding of the disclosure, in the detailed description below, corresponding elements or parts of different embodiments will be denoted with identical reference numerals in the drawings.

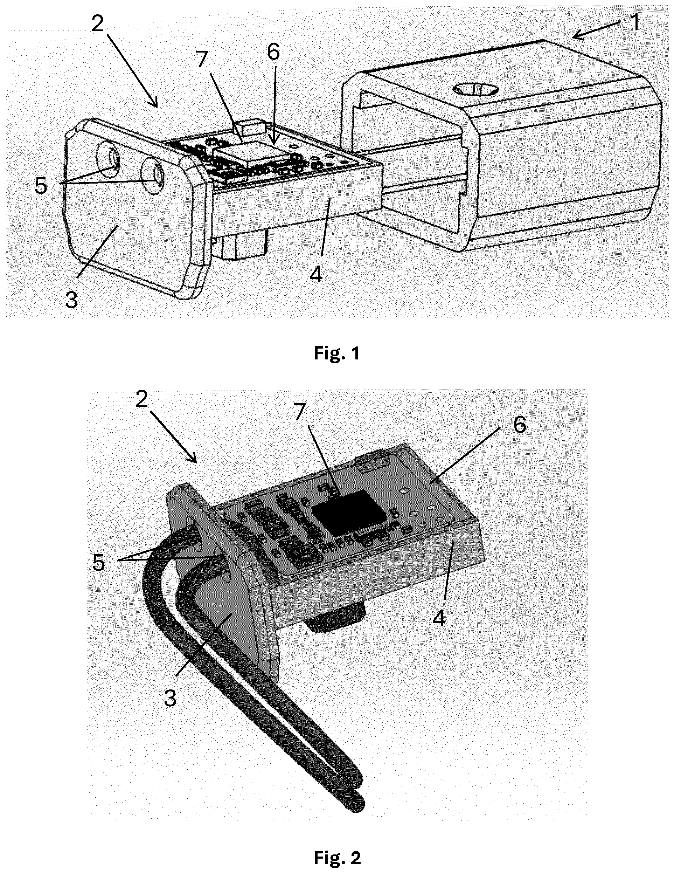

The present invention discloses a sensor module comprising a housing part 1 and a carrier part 2, which are denoted on Fig. 1 and 2. The carrier part 2 comprises a front panel 3 and a holding part 4 attached to the front panel 3. This attachment is preferably disconnectable connection in case the holding part 4 is damaged. The front panel 3 comprises connecting means 5 suitable for transmitting electrical signals through the front panel 3. The holding part 4 comprises an interior side 6 configured to hold at least one printed circuit board 7, PCB. The holding part 4 can hold multiple types of the PCBs 7.

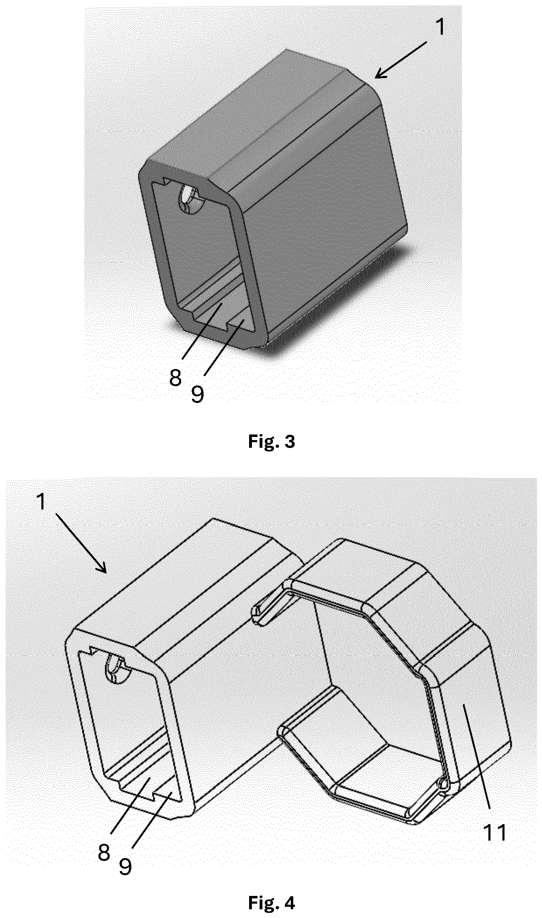

The housing part 1 is configured to receive the carrier part 2 such that an interior of the holding part 4 is enclosed within the housing part 1. Preferably an interior of the housing part 1 comprises at least one interior wall 9 with at least one guide 8 which is suitable and configured to have the carrier part 2 inserted. The guide 8 can be placed on the one interior wall 9 of the interior of the housing part 8. In the case of two guides 8, they can be placed on opposite walls, being interior walls 9, to facilitate an insertion of the carrier part 2. The housing part 1 may comprise a hole on the top wall, which is seen on Fig. 3, which is configured to be used by a light sensor to get light.

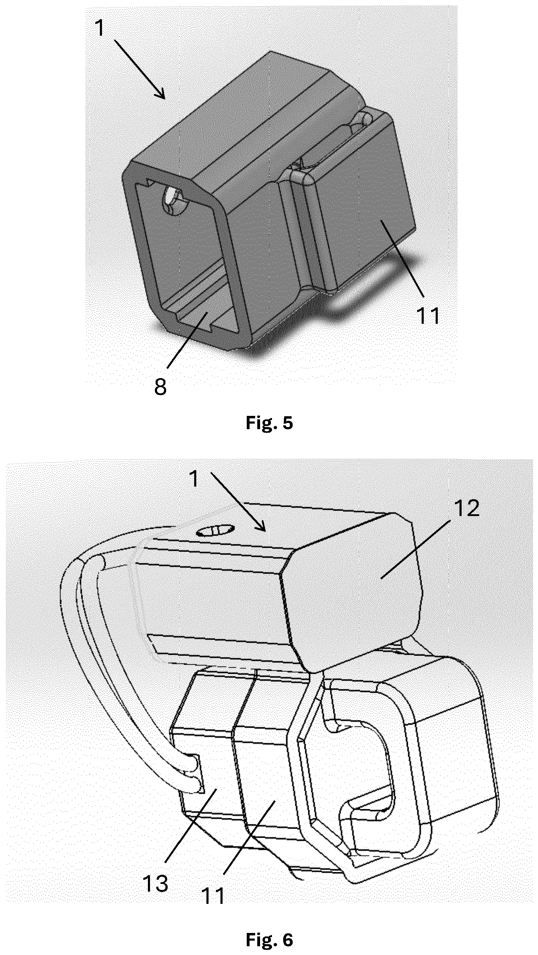

In this embodiment, the connecting means 5 is a wire interface, a connector or at least one through hole. Fig. 2 and 6 depict the wire interface with connected wires which are configured to be plugged into a transducer.

In this embodiment, at least two walls of the housing part 1 are configured to receive the carrier part 2 in a manner of sliding movement of the carrier part 2.

In this embodiment, the housing part 1 comprises a mechanical fixture 11 configured to assembly the sensor module to a final location or to attach the sensor module for an integration with another module, preferably the transducer. Preferably, the mechanical fixture 11 is a CT holder, depicted on Fig. 4, or strap holder, depicted on Fig. 5. The skilled person in the art will deduce that any type of a holder which is configured to hold another module is suitable to be used as the mechanical fixture 11. The mechanical fixture 11 is preferable but not necessary.

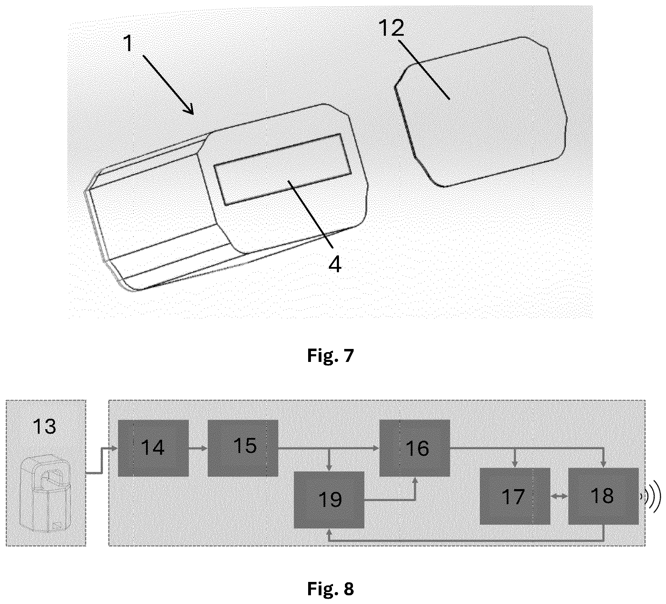

In this embodiment, to ensure stability of the carrier part 2 in the housing part 1, the additional means are used. The carrier part 2 is kept inside the housing part 1 by a sticker 12, depicted on Fig. 6 and 7, latches, snaps or a plate with screws.

Another aspect of the invention is a measuring device. The measuring device comprises a sensor module according to the above disclosure, an energy harvesting transducer 13 and at least one printed circuit board 7, PCB. The PCB 7 is configured to obtain the energy from the energy harvesting transducer 13, store the energy, indicate a level of the energy being stored, measure the measured physical quantity and transmit a measured data wirelessly. A cooperation of the sensor module with the external energy harvesting transducer 13 is shown on Fig. 8.

The energy harvesting transducer 13 is preferably configured to convert an energy, preferably the energy from a measured physical quantity or pure energy source utilized only to power the sensor module. In other embodiments, the energy harvesting transducer 13 can measure other quantities. If the sensor module is connected to an inductive transducer, the inductive transducer harvests the energy from a magnetic field and powers the sensor module. The PCB 7 can comprise plural sensors which measure different quantities what allows for simultaneous measure of these quantities. In another embodiment, the sensor module can measure different quantities and power up itself from a single source of the energy.

The PCB 7 is mounted on a carrier part 2 of the sensor module and the PCB 7 is electrically coupled, through connecting means 5 in a front panel 3 of the carrier part 2 of the sensor module, with the energy harvesting transducer 13, it is depicted on Fig. 6.

In this embodiment, the PCB 7comprises an energy harvester 14 or an energy storage 15 or a load switch 16 or a voltage supervisor 19 or at least one sensor 17 or a BLE SoC 18. The possible sensors are depicted on a block diagram on Fig. 8.

In this embodiment, the sensor is a temperature sensor or a RH sensor or a light sensor or a magnetic sensor or an accelerometer sensor or a pressure sensor. The sensor module with an implemented PCB 7, where the sensor integrated on the PCB 7is the temperature sensor, can measure ambient temperature.

In this embodiment, the connection means 5 is a wire interface or a connector and the connection of the sensor module and the energy harvesting transducer 13 is provided by a wire connection between them like it is shown on Fig. 6.

In this embodiment, the sensor module and the energy harvesting transducer13 are attached one to another in a separable manner by a mechanical fixture 11 like it is shown on Fig. 6. The sensor module can cooperate with the energy harvesting transducer 13 by putting them next to each other. The mechanical fixture 11 is preferable but not necessary. The mechanical fixture 11 increases the convenience of use of the measuring device.

## Claims

1. A sensor module comprising:
a housing part (1), and
a carrier part (2),
wherein the carrier part (2) comprising a front panel (3) and a holding part (4) attached to the front panel (3), wherein the front panel (3) comprises connecting means (5) suitable for transmitting electrical signals through the front panel (3),
wherein the holding part (4) comprising an interior side (6) configured to hold at least one printed circuit board (7), PCB,
wherein the housing part (1) is configured to receive the carrier part (2) such that the holding part (4) is enclosed within the housing part (1), preferably the housing part (1) comprising at least one interior wall (9) with at least one guide (8) which is suitable and configured to have the carrier part (2) inserted.

2. The sensor module according to claim 1, wherein the connecting means (5) is a wire interface, a connector or at least one through hole.

3. The sensor module according to claim 1 or 2, wherein at least two walls of the housing part (1) are configured to receive the carrier part (2) in a manner of sliding movement of the carrier part (2).

4. The sensor module according to claim 1, 2 or 3, wherein the housing part (1) comprises a mechanical fixture (11) configured to assembly the sensor module to a final location or to attach the sensor module for an integration with another module, wherein the mechanical fixture (11) is preferably a CT holder or strap holder.

5. The sensor module according to any claim between 1-4, wherein the carrier part (2) is kept inside the housing part (1) by a sticker (12), latches, snaps or a plate with screws.

6. A measuring device comprising:
a sensor module according to claims 1-5,
an energy harvesting transducer (13), preferably configured to convert an energy from a measured physical quantity,
at least one printed circuit board (7), PCB, configured to obtain the energy from the energy harvesting transducer (13), store the energy, indicate a level of the energy being stored, measure the measured physical quantity, and transmit a measured data wirelessly,
where the printed circuit board (7), PCB, is mounted on a carrier part (2) of the sensor module and the PCB (7) is electrically coupled, through connecting means (5) in a front panel (3) of the carrier part (2) of the sensor module, with the energy harvesting transducer (13).

7. The measuring device according to claim 6, wherein the printed circuit board (7), PCB, comprises an energy harvester (14) or an energy storage (15) or a load switch (16) or a voltage supervisor (19) or at least one sensor (17) or a BLE SoC (18).

8. The measuring device according to claim 6 or 7, wherein the sensor is a temperature sensor or a RH sensor or a light sensor or a magnetic sensor or an accelerometer sensor or a pressure sensor.

9. The measuring device according to claim 6, 7 or 8, wherein the connection means (5) is a wire interface or a connector and the connection of the sensor module and the energy harvesting transducer (13) is provided by a wire connection between them.

10. The measuring device according to claim 6, 7, 8 or 9, wherein the sensor module and the energy harvesting transducer (13) are attached one to another in a separable manner by a mechanical fixture (11).
